# EUROPÄISCHE PATENTSCHRIFT

(11) **EP 2 847 786 B1**
(45) Veröffentlichungstag und Bekanntmachung des Hinweises auf die Patenterteilung: **27.04.2016**
(21) Anmeldenummer: 12742878.7
(22) Anmeldetag: 26.07.2012
(51) Int. Cl.: H01L 31/18

(54) **VERFAHREN ZUM BONDEN VON SUBSTRATEN**
METHOD FOR BONDING SUBSTRATES
PROCÉDÉ DE CONNEXION DE SUBSTRATS

(43) Veröffentlichungstag der Anmeldung: 18.03.2015
(73) Patentinhaber: Ev Group E. Thallner GmbH, 4782 St. Florian am Inn (AT)
(72) Erfinder: WIMPLINGER, Markus, A-4910 Ried im Innkreis (AT)
(74) Vertreter: Schweiger, Johannes
(86) Internationale Anmeldenummer: PCT/EP2012/064736
(87) Internationale Veröffentlichungsnummer: WO 2014/015912

(56) Entgegenhaltungen:
- EP-A2- 1 798 774
- WO-A1-2009/136863
- US-A1- 2010 187 555
- SUGA T ET AL: "Combined process for wafer direct bonding by means of the surface activation method", ELECTRONIC COMPONENTS AND TECHNOLOGY, 2004. ECTC '04. PROCEEDINGS LAS VEGAS, NV, USA JUNE 1-4, 2004, PISCATAWAY, NJ, USA,IEEE, Bd. 1, 1. Juni 2004 (2004-06-01), Seiten 484-490, XP010714714, DOI: 10.1109/ECTC.2004.1319383 ISBN: 978-0-7803-8365-4

## Beschreibung

Die vorliegende Erfindung betrifft ein Verfahren zum Bonden einer ersten Kontaktfläche eines ersten Substrats mit einer zweiten Kontaktfläche eines zweiten Substrats.

Die gattungsgemäßen Verfahren dienen insbesondere zur Herstellung von mehrschichtigen Halbleiter-, Glas- oder Karamikverbunden. Eine besonders wichtige Anwendung betrifft die Herstellung von photovoltaischen Mehrschichtzellen.

Die Druckschrift EP 1 798 774 A2 offenbart ein Verfahren zur Erzeugung von Solarzellenteilen mit gebondeten Zwischenschichten. Die Druckschrift US 2010/187555 zeigt eine LED, wobei Licht durch elektrisch leitfähiges ZnO läuft. Die Druckschrift WO 2009/136863 A1 zeigt ein Verfahren zur Herstellung einer elektrisch leitfähigen Struktur für ein lichtdurchlässiges Gerät.

Eine der Hauptlimitierungen in der Herstellung von Mehrschichtzellen ist die Inkompatibilität der Gitterstrukturen der einzelnen Halbleitermaterialien hinsichtlich ihrer Dimension und Form. Dies führt bei der Herstellung der einzelnen Schichten durch direktes Aufwachsen der Schichten aufeinander zu Defekten in der, damit realisierten Halbleiterschicht. Diese Defekte beeinträchtigen die Qualität der erzeugten Schicht und insbesondere dem erzielbaren Wirkungsgrad für die Umwandlung von Licht in elektrische Energie. Daraus resultieren in der Praxis Einschränkungen hinsichtlich folgender Parameter:
a) Anzahl der realisierbaren aktiven Schichten im Aufbau. Dies ist aufgrund der oben beschriebenen Problematik heute auf 2 bis maximal drei Schichten begrenzt.
b) Optimierung der einzelnen Schichten hinsichtlich optimalem Wellenlängenbereich. In der Praxis ist es heute nicht möglich, die einzelnen Schichten völlig frei hinsichtlich dem optimalen Wellenlängenbereich und damit assoziierten Umwandlungscharakteristiken für die Umwandlung von Licht in elektrische Energie zu optimieren, da immer hinsichtlich Kompatibilität der Gitterstruktur Kompromisse eingegangen werden müssen.
c) Einsatz günstigerer Materialien: Für bestimmte Wellenlängen wäre es wünschenswert, beispielsweise Silizium oder Germanium einzusetzen, da diese Materialien einen idealen Kompromiss zwischen Wirkungsgrad und Kosten erlauben würden. Häufig ist der Einsatz dieser Materialien jedoch nicht möglich, da die Gitterstruktur nicht ausreichend kompatibel mit den anderen, in der Zelle verwendeten Strukturen ist.

Aufgabe der vorliegenden Erfindung ist es daher, ein Verfahren anzugeben, mit dem die Herstellung von vorgenannten Mehrschichtverbunden effizienter und mit vielseitigeren Parametern ermöglicht wird.

Diese Aufgabe wird mit den Merkmalen des Anspruchs 1 gelöst. Vorteilhafte Weiterbildungen der Erfindung sind in den Unteransprüchen angegeben.

Der Erfindung liegt der Gedanke zugrunde, statt eines Aufwachsens der Schichten zwei Substrate zu Bonden und durch das Bonden die mehreren Schichten mit verschiedenen Eigenschaften (insbesondere optischen) versehen zu können.

Der Erfindung liegt dabei insbesondere der Ansatz zugrunde, die einzelnen, im Zellenaufbau befindlichen Schichten, insbesondere die zum Bonden vorgesehene Verbindungsschicht, auf separaten Substraten vor einer Kontaktierung herzustellen und erst später zu stapeln/bonden. Damit können die einzelnen Schichten auf dafür optimierten Wachstumssubstraten hergestellt werden. Dies ist insbesondere mittels Aufwachsen durch MOCVD möglich.

Ein Aspekt der vorliegenden Erfindung besteht darin, wie diese Schichten in einer elektrisch leitfähigen und optisch transparenten Form mit einem gleichzeitig kostengünstigen Prozess gestapelt werden können. Darüber hinaus wird die, dafür notwenige Vorbereitung der Substrate beschrieben.

Das dabei beschriebene Verfahren eignet sich mit Vorzug für das Stapeln von Mehrschichtsolarzellen. Alternativ kann das Verfahren aber auch zur Erzeugung jeglicher anderer Strukturen und Bauteile eingesetzt werden, bei denen optisch transparente und elektrisch leitfähige Verbindungen zwischen beliebigen (insbesondere optischen) Materialien, insbesondere Halbleitermaterialien, Gläsern und Keramiken notwendig sind. In diesem Segment ergeben sich zunehmend mehr Anwendungen aufgrund der stark steigenden Bedeutung von Festkörper-Lichtquellen wie LEDs und Laser in einer Vielzahl von Anwendungen wie Beleuchtung, Kommunikation, Materialbearbeitung. Auch im Segment der Displayfertigung gewinnen neue, innovative Fertigungstechnologien zunehmend an Bedeutung, da zusätzliche Funktionen wie Berührungsdetektion (Feedback im Bereich von Touch Screens, etc.) in Displays integriert werden sollen.

Vorteile der Erfindung sind vor allem:
- Elektrisch Leitfähiges, optisch transparentes Bonding-Interface (Verbindungsschicht),
- Sehr dünne, roboste und langzeit-stabile Schicht(en),
- Temperaturbeständige Schicht(en) und
- hohe Effizienz (schnell & kostengünstig in der Herstellung)

Ein zentraler Aspekt der vorliegenden Erfindung ist die Nutzung von transparenten, leitfähigen Oxiden zur Herstellung der elektrisch leitfähigen und optisch transparenten Verbindungsschicht zwischen den Substraten. Die Verbindung wird insbesondere mittels Wafer Bonding, bevorzugt mit einem Direktbondverfahren und noch bevorzugter einem Direktbondverfahren mit Plasma-Aktivierung hergestellt.

Als transparente, elektrisch leitfähigen Oxide (auf Englisch auch "Transparent Conductive Oxides" oder kurz "TCO" genannt) wird insbesondere Indium-Zinn-Oxid (Englisch: "Indium-tin-oxide" oder kurz "ITO") eingesetzt. Nachfolgend soll hier die Abkürzung ITO für Indium-Zinn-Oxid verwendet werden. ITO findet breite Anwendung in der Herstellung von LCD Displays, wo es als optisch transparenter elektrischer Leiter zum Einsatz kommt. Alternativ werden folgende Materialen verwendet:
- dotierte Zink-Oxide, insbesondere Aluminium-dotiertes Zink-Oxid (Englisch: "Aluminum doped Zinc Oxide" kurz: "AZO"), Gallium dotiertes Zink-Oxid (Englisch: "Gallium doped Zinc Oxide" kurz: "GZO"),
- Fluor-dotierte Zinn-Oxide (Englisch: "Fluorine Tin Oxide" kurz: "FTO"), sowie
- Antimon-Zinn-Oxid (Englisch: "Antimony Tin Oxide" kurz: "ATO") Grundsätzlich kann jedes Material, das oxidierbar ist, und insbesondere mit entsprechender Dotierung die gewünschten Eigenschaften elektrische Leitfähigkeit und optische Transparenz aufweist, verwendet werden.

Erfindungsgemäß wird in diesem Zusammenhang von elektrischer Leifähigkeit gesprochen, wenn das Material eine Leitfähigkeit von >10e1 S/cm, bevorzugt von 10e2 S/cm und noch bevorzugter von >10e3 S/cm (gemessen mit der in der Halbleitertechnologie üblichen Vierpunktmethode, bezogen auf eine Temperatur von 300K) verfügt. Die optische Transmission (Transmissionsgrad), definiert als jener Prozentsatz des Lichtes, eines bestimmten Wellenlängenbereiches, der verwendungsgemäß die Schicht passieren soll, soll durch einen Film mit verwendungsgemäßer Dicke mindestens >80%, mit Vorteil >87%, bevorzugt >93% und noch bevorzugter >96% betragen.

Wellenlängenbereiche, die von 300nm bis 1800nm reichen, sind bevorzugt für Photovoltaikanwendungen. Das heißt, dass der relevante Wellenlängenbereich jedenfalls größer ist als der für Menschen sichtbare Wellenlängenbereich. Dies soll gewährleisten, dass auch der UV Anteil im Licht und der IR Anteil im Licht in elektrische Energie umgewandelt werden können. Da bei einer Mehrschicht-Solarzelle die oberste Schicht bereits einen Teil des Spektrums verarbeitet, und somit in elektrische Energie umwandelt, ist es akzeptabel, wenn die Bondverbindung einen etwas kleineren Wellenlängenbereich aufweist, in dem sie Transmission zulässt. Insbesondere sollen daher die oben genannten Transmissionswerte zumindest für Wellenlängen > 600 nm, mit Vorteil >500 nm und mit größerem Vorteil >400 nm und mit allergrößtem Vorteil >350 nm gelten. Weiters sollen die Transmissionswerte insbesondere auch für den gesamten Wellenlängenbereich ausgehend von der minimalen Wellenlänge bis maximal 1300 nm, mit Vorteil bis maximal 1500 nm, mit größerem Vorteil bis maximal 1700 nm und mit allergrößtem Vorteil bis maximal 1800 nm gelten.

Die Oxide werden erfindungsgemäß insbesondere mittels folgender Verfahren auf die zu verbindenden Substrate aufgebracht:
- MO CVD, Metal Organic Molecular Beam Deposition,
- Spray Pyrolyse, Pulsed Laser Deposition (PLD) oder
- Aufsputtern.

Um die gewünschten Eigenschaften der Schichten zu gewährleisten, ist es erfindungsgemäß kritisch, das richtige Mischungsverhältnis zu gewährleisten. Insbesondere der Anteil von Sauerstoff kann bei einigen dieser Oxide die optische Transparenz verbessern, wobei sichergestellt werden muss, dass der Sauerstoffanteil nicht zu hoch ausfällt, da ansonsten die elektrische Leitfähigkeit reduziert wird.

Generell wird die Bondverbindung (Verbindungsschicht, auch Bonding-Interface) hergestellt, indem auf die zu verbondenden Substrate ein Precursor Schichtaufbau abgeschieden wird. Anschließend werden die Schichten plasmaaktiviert und, insbesondere bei Raumtemperatur, gefügt, wodurch ein Pre-Bond (temporärer Bond) entsteht. Während dem darauf folgenden Wärmebehandlungsprozess (Annealing) wird der Pre-Cursor-Schichtaufbau in eine Schicht bestehend aus transparentem, elektrisch leitfähigem Oxid umgewandelt, wobei gleichzeitig die Bondverbindung gestärkt wird.

Eine erfindungsgemäße Ausführungsform des Verfahrens wird anhand zweier Halbleiterwafer (erstes und zweites Substrat) beschrieben. Das Verfahren kann aber analog auch auf jegliche andere, optisch spezifische Materialkombination angewendet werden.

In einem ersten Modul (Beschichtungsanlage) wird auf einem ersten Träger, welcher insbesondere durch das Substrat selbst gebildet ist (spätere Rückdünnung), der sich aufgrund seiner Kristallstruktur und seiner Oberfläche zum Aufwachsen einer ersten Halbleiterschicht (erstes Substrat) eignet, die erste Halbleiterschicht aufgewachsen. Darauf wird in-situ, das heißt, ohne das Substrat aus der Beschichtungsanlage, die für das Aufwachsen der Halbleiterschicht verwendet wurde, herauszunehmen, eine Schicht (erste Oxidschicht) des ausgewählten TCO abgeschieden. Der in-situ Prozess gewährleistet, dass dieses TCO direkt am Halbleiter anhaften kann, ohne dass dieser ein Oxid bilden könnte, welches die elektrische Leitfähigkeit beeinflussen würde. Dies ist insbesondere dann gewährleistet, wenn das Substrat in-situ in der (aus weiteren Modulen bestehenden) Anlage in einer Schutzatmosphäre transportiert wird, die möglichst frei von oxidierenden Elementen in der Atmosphäre ist. Dies ist insbesondere in Atmosphären gewährleistet, die weitgehend frei von Sauerstoff und Wasser sind. Mit Vorzug wird dies durch Ausgestaltung der Anlage mit Hochvakuum Atmosphäre gewährleistet, in der der Druck weniger als le-5 mbar, bevorzugt weniger als 1e-6 mbar und mit größtem Vorzug weniger als 1e-7 mbar beträgt.

Auf einem zweiten Träger, der hinsichtlich Kristallstruktur und Oberfläche für das Aufwachsen einer zweiten Halbleiterschicht (zweites Substrat) optimiert ist, wird die zweite Halbleiterschicht aufgewachsen. In-situ wird auf dieser Schicht eine TCO Schicht (zweite Oxidschicht) bestehend aus einem ausgewählten TCO-Material abgeschieden.

Auf dieser Schicht TCO 2" wird anschließend eine Pre-Cursor Schicht (dritte Oxidschicht) mit der Schichtdicke **D3** abgeschieden. Diese Pre-Cursor Schicht ist so gewählt, dass hier das Material noch nicht vollständig oxidiert ist, sondern im Vergleich zur bereits abgeschiedenen TCO Schicht (zweite Oxidschicht) einen Sauerstoffmangel aufweist. Insbesondere fehlen mindestens >30%, mit Vorzug mindestens >45% und mit noch größerem Vorzug mind. >60%, mit allergrößtem Vorzug >75% des Sauerstoffvolumens Sₘₐₓ, das für eine vollständige Oxidation notwendig wäre.

Auf dieser Pre-Cursor-Schicht wird anschließend eine TCO Schicht (vierte Oxidschicht) bestehend aus dem gewählten TCO Material mit einer Dicke D4 abgeschieden.

D3 wird dabei so groß gewählt, dass ausreichend Volumen vorhanden ist, um während der Reaktion später einen ausreichend großen Volumenanwuchs zu gewährleisten, so dass ein vollständiges Schließen der Fehlstellen im Bonding Interface gewährleistet ist. Gleichzeitig wird die Schichtdicke so gering gewählt, dass mit Vorzug das gesamte, in dieser Schicht enthaltene Material während des Prozesses vollständig oxidiert wird. Dies ist insbesondere für Schichtdicken mit einer Dicke von 1 bis 10 nm gewährleistet. Mit Vorzug liegt die Schichtdicke zwischen 1 bis 7 nm. Mit noch größerem Vorzug liegt die Schichtdicke zwischen 1 und 5 nm.

D4 wird dabei so gewählt, dass die Schichtdicke ausreichend groß ist, um die darunter liegende Schicht D3 vor einer Reaktion in der Umgebungsatmosphäre zu schützen. Insbesondere soll weitgehend verhindert werden, dass die Pre-Cursorschicht mit Sauerstoff oder Feuchtigkeit aus der Umgebungsatmosphäre reagiert, insbesondere oxidiert. Unter weitgehend ist in diesem Zusammenhang zu verstehen, dass bei einem Aussetzen des Substrates gegenüber der Umgebungsatmosphäre bei Raumtemperatur für eine Dauer von maximal 2 Stunden mit Vorteil weniger als 20% der Pre-Cursor-Schicht reagieren soll. Mit noch größerem Vorteil reagieren weniger als 10% dieser Pre-Cursor-Schicht. Mit allergrößtem Vorteil reagieren weniger als 5% dieser Pre-Cursor-Schicht. Dies ist insbesondere für Schichtdicken der Pre-Cursorschicht von mindestens 0,5 bis 1nm gewährleistet. Gleichzeitig soll die Schicht jedoch dünn genug sein, um später ein Diffundieren der Edukte / des Edukts aus dem Reservoir (siehe weiter unten) zu erlauben. Daher ist die maximale Dicke dieser Schicht mit Vorteil maximal 2 bis 3 nm. Mit noch größerem Vorteil liegt die maximale Schichtdicke bei maximal 1,5 bis 2 nm. Mit allergrößtem Vorteil liegt die maximale Schichtdicke bei maximal 1 bis 1,5 nm.

Anschließend wird das erste Substrat einem Plasma Aktivierungsprozess unterzogen, um ein Reservoir zu erzeugen (Reservoirbildung siehe weiter unten).

Anschließend werden die Substrate bei Raumtemperatur verbondet, Dabei stellen Van-der-Waals Kräfte sicher, dass die Substrate schon bei Raumtemperatur aneinander haften. Während einem späteren Annealing Prozess difffundiert ein in dem Reservoir eingelagertes erstes Edukt, insbesondere H₂O, durch die (insbesondere ebenfalls vorher mit Plasma beaufschlagte) vierte Oxidschichtschicht und oxidiert die dritte Oxidschicht. Dadurch steigt das Volumen des oxidierten Materials, was zum Schließen der Fehlstellen in der Oberfläche führt (Aufwuchsschicht).

Anschließend können optional einer oder beide der Träger - soweit vorhanden - entfernt werden. Alternativ könnte auch einer der Träger ebenfalls ein Halbleiterwafer sein, der später Teil der finalen Struktur wird.

Ein weiterer Aspekt der vorliegenden Erfindung ist es, mit Hilfe eines kapazitiv gekoppelten Plasmas oder eines induktiv gekoppelten Plasmas oder einem Plasma aus einer Remoteplasmaanlage ein Plasma zu erzeugen, mit dessen Hilfe ein Reservoir zur Aufnahme eines ersten Edukts in einem Substrat geschaffen wird, das nach der Kontaktierung beziehungsweise Herstellung eines vorläufigen Bonds zwischen den Substraten mit einem zweiten Edukt, das in dem anderen Substrat vorliegt, reagiert und dadurch einen irreversiblen beziehungsweise permanenten Bond zwischen den Substraten ausbildet. Vor oder nach der Ausbildung des Reservoirs in einer Oxidschicht an der ersten Kontaktfläche findet meist eine Reinigung des oder der Substrate, insbesondere durch einen Spülschritt, statt. Diese Reinigung soll zumeist sicherstellen, dass sich keine Partikel auf den Oberflächen befinden, die ungebondete Stellen zur Folge haben würden. Durch das Reservoir und das im Reservoir enthaltene Edukt wird eine technische Möglichkeit geschaffen, unmittelbar an den Kontaktflächen nach der Herstellung des vorläufigen beziehungsweise reversiblen Bonds gezielt eine den permanenten Bond verstärkende und die Bondgeschwindigkeit erhöhende Reaktion (erstes Edukt oder erste Gruppe mit dem zweiten Edukt oder der zweiten Gruppe) zu induzieren, insbesondere durch Verformung mindestens einer der Kontaktflächen durch die Reaktion, vorzugsweise der dem Reservoir gegenüberliegenden Kontaktfläche. An der gegenüberliegenden zweiten Kontaktfläche ist erfindungsgemäß eine Aufwuchsschicht vorgesehen, in der die erfindungsgemäße Verformung stattfindet beziehungsweise das erste Edukt (oder die erste Gruppe) mit dem in der Reaktionsschicht des zweiten Substrats vorliegenden zweiten Edukt (oder der zweiten Gruppe) reagiert. Zur Beschleunigung der Reaktion zwischen dem ersten Edukt (oder der ersten Gruppe) und dem zweiten Edukt (oder der zweiten Gruppe) ist erfindungsgemäß in einer vorteilhaften Ausführungsform vorgesehen, die zwischen der Reaktionsschicht des zweiten Substrats und dem Reservoir liegende Aufwuchsschicht vor Kontaktierung der Substrate zu dünnen, da hierdurch der Abstand zwischen den Reaktionspartnern einstellbar verringert wird und gleichzeitig die erfindungsgemäße Verformung/Ausbildung der Aufwuchsschicht begünstigt wird. Die Aufwuchsschicht wird durch das Dünnen zumindest teilweise, insbesondere überwiegend, vorzugsweise vollständig, entfernt. Die Aufwuchsschicht wächst bei der Reaktion des ersten Edukts mit dem zweiten Edukt wieder an, auch wenn diese vollständig entfernt wurde. Das Dünnen dieser Aufwuchsschicht könnte erfindungsgemäß insbesondere mittels Ätzen, insbesondere Trockenätzen, Polieren, Sputtern oder Reduktion von Oxiden erfolgen. Mit Vorzug ist auch eine Kombination dieser Verfahren, insbesonderer Sputtern und Oxidreduktion, denkbar.

Erfindungsgemäß können Mittel zur Hemmung des Anwachsens der Aufwuchsschicht vor dem Kontaktieren der Kontaktflächen vorgesehen sein, insbesondere durch Passivierung der Reaktionsschicht des zweiten Substrats, vorzugsweise durch Beaufschlagung mit N₂, Formiergas oder einer inerten Atmosphäre oder unter Vakuum oder durch Amorphisieren. Als besonders geeignet hat sich in diesem Zusammenhang eine Behandlung mit Plasma, welches Formiergas enthält, insbesondere überwiegend aus Formiergas besteht, erwiesen. Als Formiergas sind hier Gase zu verstehen, die mindestens 2%, besser 4%, idealerweise 10% oder 15% Wasserstoff enthalten. Der restliche Anteil der Mischung besteht aus einem inerten Gas wie beispielsweise Stickstoff oder Argon.

Bei der Verwendung von Formiergas ist es insbesondere möglich, die Oxidschicht durch einen Prozess, der auf Sputtern und Oxidreduktion beruht, zu dünnen.

Alternativ oder zusätzlich zu dieser Maßnahme ist es erfindungsgemäß von Vorteil, die Zeit zwischen dem Dünnen und der Kontaktierung zu minimieren, insbesondere <2 Stunden, vorzugsweise <30 Minuten, noch bevorzugter <15 Minuten, idealerweise <5 Minuten. Damit lässt sich das Oxidwachstum, welches nach dem Dünnen erfolgt, minimieren.

Durch die gedünnte und dadurch zumindest beim Beginn der Ausbildung des permanenten Bonds beziehungsweise beim Beginn der Reaktion sehr dünne Aufwuchsschicht wird die Diffusionsrate der Edukte durch die Aufwuchsschicht hindurch erhöht. Dies führt zu einer geringeren Transportzeit der Edukte bei gleicher Temperatur.

Für den Pre-Bonding-Schritt zur Erzeugung eines vorläufigen oder reversiblen Bonds zwischen den Substraten sind verschiedene Möglichkeiten vorgesehen mit dem Ziel, eine schwache Interaktion zwischen den Kontaktflächen der Substrate zu erzeugen. Die Prebondstärken liegen dabei unter den Permanentbondstärken, zumindest um den Faktor 2 bis 3, insbesondere um den Faktor 5, vorzugsweise um den Faktor 15, noch bevorzugter um den Faktor 25.Als Richtgrößen werden die Pre-Bondstärken von reinem, nicht aktiviertem, hydrophilisierten Silizium mit ca. 100mJ/m² und von reinem, plasmaaktivierten hydrophiliserten Silizium mit ca. 200-300mJ/m² erwähnt. Die Prebonds zwischen den mit Molekülen benetzten Substraten kommen hauptsächlich durch die van-der-Waals Wechselwirkungen zwischen den Molekülen der unterschiedlichen Waferseiten zustande. Dementsprechend sind vor allem Moleküle mit permanenten Dipolmomenten dafür geeignet, Prebonds zwischen Wafern zu ermöglichen. Als Verbindungsmittel werden folgende chemische Verbindungen beispielhaft, aber nicht einschränkend, genannt
- Wasser,
- Tiole,
- AP3000,
- Silane und/oder
- Silanole

Als erfindungsgemäße Substrate sind solche Substrate geeignet, deren Material in der Lage ist, als Edukt mit einem weiteren zugeführten Edukt zu einem Produkt mit einem höheren molaren Volumen zu reagieren, wodurch die Bildung einer Aufwuchsschicht auf dem Substrat bewirkt wird. Besonders vorteilhaft sind die nachfolgenden Kombinationen, wobei jeweils links vom Pfeil das Edukt und rechts vom Pfeil das Produkt / die Produkte genannt ist, ohne das mit dem Edukt reagierende zugeführte Edukt oder Nebenprodukte im Einzelnen zu benennen:
- Si → SiO₂, Si₃N₄, SiNₓO_{y}
- Ge → GeO₂, Ge₃N₄
- α-Sn → SnO₂
- B → B₂O₃, BN
- Se → SeO₂
- Te → TeO₂, TeO₃
- Mg → MgO, Mg₃N₂
- Al → Al₂O₃, AlN
- Ti → TiO₂, TiN
- V → V₂O₅
- Mn → MnO, MnO₂, Mn₂O₃, Mn₂O₇, Mn₃O₄
- Fe → FeO, Fe₂O₃, Fe₃O₄
- Co → CoO, Co₃O₄,
- Ni → NiO, Ni₂O₃
- Cu → CuO Cu₂O, Cu₃N
- Zn → ZnO
- Cr → CrN, Cr₂₃C₆, Cr₃C, Cr₇C₃, Cr₃C₂
- Mo → Mo₃C₂
- Ti → TiC
- Nb → Nb₄C₃
- Ta → Ta₄C₃
- Zr → ZrC
- Hf → HfC
- V → V₄C₃, VC
- W → W₂C, WC
- Fe → Fe₃C, Fe₇C₃, Fe₂C.
- In → In₂O₃
- Sn → Sn₂O₂
- Sn → SnO
- Zn → ZnO
- Al → Al₂O₃

Als Substrate sind außerdem folgende Mischformen von Halbleitern denkbar:
- III-V: GaP, GaAs, InP, InSb, InAs, GaSb, GaN, AlN, InN, AlₓGa₁₋ₓAs, InₓGa₁₋ₓN
- IV-IV: SiC, SiGe,
- III-VI: InA1P.
- nichtlineare Optik: LiNbO₃, LiTaO₃, KDP (KH₂PO₄)
- Solarzellen: CdS, CdSe, CdTe, CuInSe₂, CuInGaSe₂, CuInS₂, CuInGaS₂
- Leitende Oxide: In₂₋ₓSnxO_{3-y}

Erfindungsgemäß wird das Reservoir (oder die Reservoirs) an mindestens einem der Wafer, und zwar unmittelbar an der jeweiligen Kontaktfläche, vorgesehen, in welchem eine gewisse Menge mindestens eines der zugeführten Edukte für die Volumenexpansionsreaktion speicherbar ist. Edukte können also beispielsweise O₂, O₃, H₂O, N2, NH3, H₂O₂ etc. sein. Durch die Expansion, insbesondere bedingt durch Oxidwachstum, werden auf Grund der Bestrebung der Reaktionspartner, die Systemenergie abzusenken, etwaige Lücken, Poren, Hohlräume zwischen den Kontaktflächen minimiert und die Bondkraft entsprechend durch Annäherung der Abstände zwischen den Substraten in diesen Bereichen erhöht. Im bestmöglichen Fall werden die vorhandenen Lücken, Poren und Hohlräume komplett geschlossen, sodass die gesamte Bondingfläche zunimmt und damit die Bondkraft erfindungsgemäß entsprechend steigt.

Die Kontaktflächen zeigen üblicherweise eine Rauhigkeit mit einer quadratischen Rauheit (Rq) von 0,2 nm auf. Dies entspricht Scheitel-ScheitelWerten der Oberflächen im Bereich von 1 nm. Diese empirischen Werte wurden mit der Atomic Force Microscopy (AFM) ermittelt.

Die erfindungsgemäße Reaktion ist geeignet, bei einer üblichen Waferfläche eines kreisförmigen Wafers mit einem Durchmesser von 200 bis 300 mm mit 1 Monolage (ML) Wasser die Aufwuchsschicht um 0,1 bis 0,3 nm wachsen zu lassen.

Erfindungsgemäß ist daher insbesondere vorgesehen, mindestens 2 ML, vorzugsweise mindestens 5 ML, noch bevorzugter mindestens 10 ML Fluid, insbesondere Wasser, im Reservoir zu speichern. Die Ausbildung des Reservoirs erfolgt durch Plasmabeaufschlagung, da durch die Plasmabeaufschlagung außerdem eine Glättung der Kontaktfläche sowie eine Hydrophilisierung als Synergieeffekte bewirkt werden. Die Glättung der Oberfläche durch Plasmaaktivierung erfolgt vorwiegend durch einen viskosen Fluss des Materials der Oxidschicht und gegebenenfalls der Reaktionsschicht. Die Erhöhung der Hydrophilizität erfolgt insbesondere durch die Vermehrung der Siliziumhydroxyl Verbindungen, vorzugsweise durch Cracken von an der Oberfläche vorhandenen Si-O Verbindungen wie Si-O-Si, insbesondere gemäß nachfolgender Reaktion:

Si-O-Si + H₂O ←→ 2SiOH

Für andere Oberflächen kann ganz generell gesagt werden, dass eine Erhöhung der Dichte der freistehenden OH Verbindungen stattfindet, was eine verbesserte Hydrophilizität zur Folge hat.

Ein weiterer Nebeneffekt, insbesondere als Folge der vorgenannten Effekte, besteht darin, dass die Pre-Bond-Stärke, insbesondere um einen Faktor 2 bis 3, verbessert wird.

Die Ausbildung des Reservoirs in der Oxidschicht an der ersten Kontaktfläche des ersten Substrats (und gegebenenfalls einer Oxidschicht an der zweiten Kontaktfläche des zweiten Substrats) erfolgt durch Plasmaaktivierung des mit einem thermischen Oxid beschichteten ersten Substrats. Die Plasmaaktivierung wird in einer Vakuumkammer durchgeführt, um die für das Plasma erforderlichen Bedingungen einstellen zu können. Erfindungsgemäß wird für die Plasmaentladung N₂-Gas, O₂-Gas oder Argongas mit Ionenenergien im Bereich von 0 bis 2000 eV (Amplitude) verwendet, wodurch ein Reservoir mit einer Tiefe von bis zu 20 nm, vorzugsweise bis zu 15 nm, mit größerem Vorzug bis zu 10nm, mit größtem Vorzug bis zu 5nm, der behandelten Oberfläche, in diesem Fall der ersten Kontaktfläche, hergestellt wird.

Durch Einstellung eines bestimmten Drucks in der Vakuumkammer ist eine Einflussnahme beziehungsweise Einstellung der mittleren freien Weglänge für die Plasmaionen erfindungsgemäß denkbar.

Durch die erfindungsgemäße Verwendung zweier unterschiedlicher Frequenzen an den gegenüberliegenden Elektroden zur Erzeugung des Plasmas, die insbesondere unter Anlegen eines Wechselstroms beziehungsweise einer Wechselspannung die Plasmaionen beschleunigen, und/oder einer induktiv gekoppelten Plasmaquelle und/oder einem Remoteplasma sind reproduzierbare Ergebnisse bei der Erzeugung des Reservoirs an der/den Kontaktflächen möglich.

Im Falle der kapazitiven Kopplung ist es vorteilhaft, wenn die Elektroden innerhalb der Plasmakammer angeordnet sind.

Dabei wird durch Einstellung der Parameter (unterschiedliche) Frequenzen der Elektroden, Amplituden, einer, insbesondere, vorzugsweise ausschließlich, an der zweiten Elektrode angelegten Biasspannung und Kammerdruck eine optimale Beaufschlagung der Kontaktflächen und somit Erzeugung eines exakt, insbesondere volumenmäßig und/oder tiefenmäßig definierten Reservoirs ermöglicht.

Die Ausführung der Plasmaaktivierungsanlage als kapazitiv gekoppelte Doppelfrequenz-Plasmaanlage ermöglicht mit Vorteil ein getrenntes Einstellen der Ionendichte und der Beschleunigung der Ionen auf die Waferoberfläche. Somit lassen sich erzielbare Prozessergebnisse in einem breiten Fenster einstellen und optimal an die Erfordernisse der Anwendung anpassen.

Die Biasspannung dient, insbesondere in Form einer Grundspannung der zweiten, insbesondere unteren, Elektrode dazu, das Auftreffen (Geschwindigkeit) der Elektroden auf die Kontaktfläche des auf der zweiten Elektrode aufgenommenen Substrats zu beeinflussen, insbesondere zu dämpfen oder zu beschleunigen.

Durch die vorgenannten Parameter wird insbesondere die Porendichteverteilung im Reservoir einstellbar, wobei nachfolgend besonders vorteilhafte Ausführungsformen beschrieben werden.

Bei einer induktiv gekoppelten Plasmaquelle können entsprechende Analogieüberlegungen über die Wechselspannung der kapazitiven Kopplung auf Wechselströme, die zur Erzeugung eines magnetischen Feldes genutzt werden, übernommen werden. Erfindungsgemäß ist es denkbar, das Plasma der induktiv gekoppelten Plasmaquelle durch einen Wechselstrom bzw. magnetisches Wechselfeld unterschiedlicher Stärke und/oder Frequenz so zu manipulieren, dass das Plasma entsprechende erfindungsgemäße Eigenschaften aufweist.

Bei einem Remoteplasma, wird das eigentlich zu verwendende Plasma in einer externen Quelle erzeugt, und in den Probenraum eingeführt. Insbesondere werden Bestandteile dieses Plasmas, insbesondere Ionen, in den Probenraum transportiert. Der Übergang des Plasmas vom Quellen- in den Substratraum kann durch unterschiedliche Elemente wie Schleusen, Beschleuniger, magnetische und/oder elektrische Linsen, Blenden etc. gewährleistet werden. Alle für das kapazitiv und/oder induktiv gekoppelte Plasma geltenden Überlegungen bezüglich Frequenzen und/oder Stärken der elektrischen und/oder magnetischen Felder soll für sämtliche Elemente, welche die Erzeugung und/oder den Übergang des Plasmas vom Quellen- in den Substratraum gewährleisten gelten. Denkbar wäre beispielsweise, dass ein Plasma durch kapazitive oder induktive Kopplung durch die erfindungsgemäßen Parameter im Quellenraum erzeugt wird und danach über die oben offenbarten Elemente in den Substratraum eindringt.

Erfindungsgemäß können jede Partikelart, Atome und/oder Moleküle, verwendet werden, die geeignet sind, das Reservoir zu erzeugen. Mit Vorzug werden jene Atome und/oder Moleküle verwendet, welche das Reservoir mit den benötigten Eigenschaften erzeugt. Die relevanten Eigenschaften sind vor allem die Porengröße, Porenverteilung und Porendichte. Alternativ können erfindungsgemäß Gasmischungen, wie beispielsweise Luft oder Formiergas bestehend aus 95% Ar und 5% H₂ verwendet werden. Abhängig von dem verwendeten Gas sind in dem Reservoir während der Plasmabehandlung unter anderem folgende Ionen anwesend: N+, N₂+, O+, O₂+, Ar+. Im nicht belegten Freiraum des/der Reservoirs ist das erste Edukt aufnehmbar. Die Oxidschicht und entsprechend das Reservoir kann sich bis in die Reaktionsschicht hinein erstrecken.

Mit Vorteil handelt es sich dabei um unterschiedliche Arten von Plasmaspezies, die mit der Reaktionsschicht reagieren können und zumindest teilweise, vorzugsweise überwiegend aus dem ersten Edukt bestehen. Soweit das zweite Edukt Si/Si ist, wäre eine Oₓ-Plasmaspezies vorteilhaft.

Die Ausbildung des/der Reservoirs erfolgt auf Grund folgender Überlegungen:
Die Porengröße ist kleiner als 10nm, mit Vorzug kleiner als 5nm, mit größerem Vorzug kleiner als 1nm, mit noch größerem Vorzug kleiner als 0.5nm, mit größtem Vorzug kleiner als 0.2nm.

Die Porendichte ist mit Vorzug direkt proportional zur Dichte der Partikel, welche die Poren durch Einschlagwirkung erzeugen, mit größtem Vorzug sogar durch den Partialdruck der Einschlagspezies variierbar, sowie abhängig von der Behandlungszeit und den Parametern, insbesondere des verwendeten Plasmasystems.

Die Porenverteilung besitzt mit Vorzug mindestens einen Bereich größter Porenkonzentration unter der Oberfläche, durch Variation der Parameter mehrerer solcher Bereiche, welche sich zu einem, vorzugsweise plateauförmigen Bereich, überlagern (siehe Fig. 8). Die Porenverteilung nimmt mit zunehmender Dicke gegen null ab. Der oberflächennahe Bereich besitzt während des Beschusses eine Porendichte, welche mit der Porendichte nahe der Oberfläche beinahe ident ist. Nach dem Ende der Plasmabehandlung kann die Porendichte an der Oberfläche auf Grund von Spannungsrelaxationsmechanismen verringert werden. Die Porenverteilung in Dickenrichtung besitzt bezüglich der Oberfläche eine steile Flanke und bezüglich des Bulks eine eher flachere, aber stetig abnehmende Flanke (siehe Fig. 8).

Für die Porengröße, die Porenverteilung und Porendichte gelten für alle nicht mit Plasma hergestellten Verfahren ähnliche Überlegungen.

Das Reservoir kann durch gezielte Verwendung und Kombination von Prozessparametern designed werden. Fig. 8 zeigt eine Darstellung der Konzentration eingeschossener Stickstoffatome durch Plasma als Funktion der Eindringtiefe in eine Siliziumoxidschicht. Durch Variation der physikalischen Parameter konnten zwei Profile erzeugt werden. Das erste Profil 11 wurde durch stärker beschleunigte Atome tiefer im Siliziumoxid erzeugt, wohingegen das Profil 12, nach Abänderung der Prozessparameter in einer geringeren Dichte erzeugt wurde. Die Überlagerung beider Profile ergibt eine Summenkurve 13, welche charakteristisch für das Reservoir steht. Der Zusammenhang zwischen der Konzentration der eingeschossenen Atom und/oder Molekülspezies ist evident. Höhere Konzentrationen bezeichnen Gebiete mit höherer Defektstruktur, also mehr Raum um das anschließende Edukt aufzunehmen. Eine kontinuierliche, insbesondere gezielt gesteuerte kontinuierliche Änderung der Prozessparameter während der Plasmaaktivierung ermöglicht es, ein Reservoir mit einer möglichst gleichmäßigen Verteilung der eingebrachten Ionen über die Tiefe zu erreichen. Diese Überlegungen gelten analog ebenfalls für andere Schichten als Siliziumoxid, in welchen das Reservoir im Falle anderer Materialkombinationen gebildet werden kann. Insbesondere sind diese Überlegungen auch für TCO Schichten anwendbar.

Als Reservoir ist alternativ zu einem durch Plasma erzeugten Reservoir die Verwendung einer TEOS (Tetraethylorthosilikat)-Oxidschiht auf mindestens einem der Substrate, zumindest dem ersten Substrat, denkbar. Diese Alternative ist nicht Bestandteil der vorliegenden Erfindung. Dieses Oxid ist im allgemeinen weniger dicht als thermisches Oxid, weshalb erfindungsgemäß eine Verdichtung vorteilhaft ist. Die Verdichtung erfolgt durch Wärmebehandlung mit dem Ziel einer Einstellung einer definierten Porosität des Reservoirs.

Besonders vorteilhaft kann gemäß einer Ausführungsform der Erfindung die Auffüllung des Reservoirs gleichzeitig mit der Ausbildung des Reservoirs erfolgen, indem das Reservoir als Beschichtung auf dem ersten Substrat aufgebracht wird, wobei die Beschichtung das erste Edukt bereits umfasst.

Das Reservoir ist als poröse Schicht mit einer Porosität im Nanometerbereich oder als Kanäle aufweisende Schicht mit einer Kanaldicke kleiner 10nm, mit größerem Vorzug kleiner als 5 nm, mit noch größerem Vorzug kleiner als 2nm, mit größtem Vorzug kleiner als 1nm, mit allergrößtem Vorzug kleiner als 0.5nm denkbar.

Für den Schritt des Auffüllens des Reservoirs mit dem ersten Edukt oder einer ersten Gruppe von Edukten sind erfindungsgemäß folgende Ausführungsformen, auch in Kombination, denkbar:
- Aussetzen des Reservoirs gegenüber der Umgebungsatmosphäre,
- Spülung mit, insbesondere deionisiertem, Wasser,
- Spülen mit einem das Edukt enthaltenden oder aus diesem bestehenden Fluid, insbesondere H₂O, H₂O₂, NH40H
- Aussetzen des Reservoirs gegenüber einer beliebigen Gasatmosphäre, insbesondere atomares Gas, molekulares Gas, Gasmischungen,
- Aussetzen des Reservoirs gegenüber einer Wasserdampf oder Wasserstoffperoxiddampf enthaltenden Atmosphäre und
- Ablagerung eines bereits mit dem Edukt befüllten Reservoirs als Oxidschicht auf dem ersten Substrat.

Als Edukte kommen die folgenden Verbindungen in Frage: Ox⁺, O₂, O₃, N₂, NH₃, H₂O, H₂O₂ und/oder NH₄OH.

Die Verwendung des oben angeführten Wasserstoffperoxiddampfes wird neben der Verwendung von Wasser als bevorzugte Variante angesehen. Wasserstoffperoxid hat des Weiteren den Vorteil, ein größeres Sauerstoff zu Wasserstoffverhältnis zu besitzen. Des Weiteren dissoziiert Wasserstoffperoxid über bestimmten Temperaturen und/oder der Verwendung von Hochfrequenzfeldern im MHz Bereich zu Wasserstoff und Sauerstoff.

Andererseits bietet H₂O den Vorteil, eine kleine Molekülgröße aufzuweisen. Die Größe des H₂O-Moleküls ist sogar kleiner als jene des O₂-Moleküls, womit H₂O den Vorteil bietet, leichter in den Poren eingelagert werden zu können, sowie leichter durch die Aufwuchsschicht hindurch diffundieren zu können.

Vor allem bei Verwendung von Materialien mit unterschiedlichen thermischen Ausdehnungskoeffizienten ist die Anwendung von Verfahren zur Dissoziierung der vorgenannten Spezies vorteilhaft, die keine nennenswerte oder allenfalls eine lokale/spezifische Temperaturerhöhung bewirken. Insbesondere ist eine Mikrowellenbestrahlung vorgesehen, welche die Dissoziierung zumindest begünstigt, vorzugsweise bewirkt.

Gemäß einer vorteilhaften Ausführungsform der Erfindung ist vorgesehen, dass die Ausbildung der Aufwuchsschicht und Verstärkung des irreversiblen Bonds durch Diffusion des ersten Edukts in die Reaktionsschicht erfolgt.

Gemäß einer weiteren, vorteilhaften Ausführungsform der Erfindung ist vorgesehen, dass die Ausbildung des irreversiblen Bonds bei einer Temperatur von typischerweise weniger als 300°C, mit Vorteil von weniger als 200°C, mit größerem Vorzug weniger als 150°C, mit noch größerem Vorzug weniger als 100°C, mit größtem Vorzug bei Raumtemperatur insbesondere während maximal 12 Tage, bevorzugter maximal 1 Tag, noch bevorzugter maximal 1 Stunde, am bevorzugtesten maximal 15 Minuten, erfolgt. Eine weitere, vorteilhafte Wärmebehandlungsmethode ist die dielektrische Erwärmung durch Mikrowellen.

Dabei ist es besonders vorteilhaft, wenn der irreversible Bond eine Bondstärke von größer 1,5 J/m², insbesondere größer 2 J/m², vorzugsweise größer 2,5 J/m² aufweist.

Die Bondstärke kann in besonders vorteilhafter Weise dadurch erhöht werden, dass bei der Reaktion erfindungsgemäß ein Produkt mit einem größeren molaren Volumen als das molare Volumen des zweiten Edukts in der Reaktionsschicht gebildet wird. Hierdurch wird ein Anwachsen am zweiten Substrat bewirkt, wodurch Lücken zwischen den Kontaktflächen durch die erfindungsgemäße chemische Reaktion geschlossen werden können. Als Folge hieraus wird der Abstand zwischen den Kontaktflächen, also der mittlere Abstand, reduziert und Toträume minimiert.

Da die Ausbildung des Reservoirs durch Plasmaaktivierung, insbesondere mit einer Aktivierungsfrequenz zwischen 10 kHz und 20000 kHz, mit Vorzug zwischen 10 kHz und 5000 kHz, noch bevorzugter zwischen 10 kHz und 1000 kHz, mit größtem Vorzug zwischen 10 kHz und 600 kHz und/oder einer Leistungsdichte zwischen 0,075 und 0,2 Watt/cm² und/oder unter Druckbeaufschlagung mit einem Druck zwischen 0,1 und 0,6 mbar, erfolgt, werden zusätzliche Effekte wie die Glättung der Kontaktfläche als auch eine deutlich erhöhte Hydrophilität der Kontaktfläche bewirkt.

Gemäß einer weiteren vorteilhaften Ausführungsform der Erfindung ist vorgesehen, dass die Oxidschicht überwiegend, insbesondere im wesentlichen vollständig, aus einem, insbesondere amorphen, insbesondere einem durch thermische Oxidation erzeugten Siliziumdioxid, und die Reaktionsschicht aus einem oxidierbaren Material, insbesondere überwiegend, vorzugsweise im wesentlichen vollständig, aus Si, Ge, InP, GaP oder GaN (oder einem anderen, oben alternativ erwähnten Material), bestehen. Durch Oxidation wird eine besonders stabile und die vorhandenen Lücken besonders effektiv schließende Reaktion ermöglicht.

Dabei ist es erfindungsgemäß vorgesehen, dass zwischen der zweiten Kontaktfläche und der Reaktionsschicht eine Aufwuchsschicht, insbesondere überwiegend aus nativem Siliziumdioxid (oder einem anderen, oben alternativ erwähnten Material), vorgesehen ist. Die Aufwuchsschicht unterliegt einem durch die erfindungsgemäße Reaktion bewirkten Wachstum. Das Wachstum erfolgt ausgehend vom Übergang Si-SiO2 (7) durch Neubildung von amorphem SiO2 und dadurch hervorgerufener Verformung, insbesondere Ausbeulung, der Aufwuchsschicht, insbesondere an der Grenzfläche zur Reaktionsschicht, und zwar insbesondere in Bereichen von Lücken zwischen der ersten und der zweiten Kontaktfläche. Hierdurch wird eine Reduzierung des Abstands beziehungsweise Verringerung des Totraums zwischen den beiden Kontaktflächen bewirkt, wodurch die Bondstärke zwischen den beiden Substraten erhöht wird. Besonders vorteilhaft ist dabei eine Temperatur zwischen 200 und 400°C, bevorzugt in etwa 200°C und 150° C, bevorzugterweise eine Temperatur zwischen 150°C und 100°C, am bevorzugtesten eine Temperatur zwischen 100°C und Raumtemperatur. Die Aufwuchsschicht kann dabei in mehrere Aufwuchsbereiche unterteilt sein. Die Aufwuchsschicht kann gleichzeitig eine Oxidschicht des zweiten Substrats sein, in der ein weiteres, die Reaktion beschleunigendes Reservoir ausgebildet wird.

Hierbei ist es besonders vorteilhaft, wenn die Aufwuchsschicht vor der Ausbildung des irreversiblen Bonds eine mittlere Dicke A zwischen 0,1 nm und 5 nm aufweist. Je dünner die Aufwuchsschicht, desto schneller und einfacher erfolgt die Reaktion zwischen dem ersten und dem zweiten Edukt durch die Aufwuchsschicht hindurch, insbesondere durch Diffusion des ersten Edukts durch die Aufwuchsschicht hindurch zur Reaktionsschicht. Durch die gedünnte und dadurch zumindest beim Beginn der Ausbildung des permanenten Bonds beziehungsweise beim Beginn der Reaktion sehr dünne Aufwuchsschicht wird die Diffusionsrate der Edukte durch die Aufwuchsschicht hindurch erhöht. Dies führt zu einer geringeren Transportzeit der Edukte bei gleicher Temperatur.

Hier spielt das erfindungsgemäße Dünnen eine entscheidende Rolle, da die Reaktion hierdurch weiter beschleunigt und/oder die Temperatur weiter reduziert werden können. Das Dünnen kann insbesondere durch Ätzen, vorzugsweise in feuchter Atmosphäre, noch bevorzugter in-situ, erfolgen. Alternativ erfolgt das Dünnen insbesondere durch Trockenätzen, vorzugsweise in-situ. In-situ bedeutet hier die Durchführung in ein und derselben Kammer, in der mindestens ein vorheriger und/oder ein nachfolgender Schritt durchgeführt wird/werden. Eine weitere Anlagenanordnung, die untern den, hier verwendeten in-situ Begriff fällt ist eine Anlage, bei der der Transport der Substrate zwischen einzelnen Prozesskammern in einer kontrolliert einstellbaren Atmosphäre, beispielsweise unter Verwendung inerter Gase, insbesondere aber in Vakuum Umgebung erfolgen kann. Nassätzen findet mit Chemikalien in der Dampfphase statt, währen Trockenätzen mit Chemikalien im flüssigen Zustand stattfindet. Soweit die Aufwuchsschicht aus Siliziumdioxid besteht, kann mit Flusssäure oder verdünnter Flusssäure geätzt werden. Soweit die Aufwuchsschicht aus reinem Si besteht, kann mit KOH geätzt werden.

In vorteilhafter Weise ist gemäß einer Ausführungsform der Erfindung vorgesehen, dass die Ausbildung des Reservoirs im Vakuum durchgeführt wird. Somit können Verunreinigungen des Reservoirs mit nicht erwünschten Materialien oder Verbindungen vermieden werden.

In einer weiteren Ausführungsform der Erfindung ist mit Vorteil vorgesehen, dass das Auffüllen des Reservoirs durch einen oder mehrere der nachfolgend aufgeführten Schritte erfolgt:
- Aussetzen der ersten Kontaktfläche gegenüber der Atmosphäre, zur Auffüllung des Reservoirs mit Luftfeuchtigkeit und / oder in der Luft enthaltenem Sauerstoff.
- Beaufschlagung der ersten Kontaktfläche mit einem, insbesondere überwiegend, vorzugsweise nahezu vollständig, aus, insbesondere deionisiertem, H₂O und/oder H₂O₂ bestehenden, Fluid,
- Beaufschlagung der ersten Kontaktfläche mit N₂-Gas und/oder O₂-Gas und/oder Ar-Gas und/oder Formiergas, insbesondere bestehend aus 95% Ar und 5% H₂, insbesondere mit einer Ionenenergie im Bereich von 0 bis 2000 eV.
- Bedampfung zur Auffüllung des Reservoirs mit einem beliebigen bereits genannten Edukt.

Besonders effektiv für den Verfahrensablauf ist es, wenn das Reservoir mit Vorzug in einer Dicke R zwischen 0,1 nm und 25 nm, mit größerem Vorzug zwischen 0,1 nm und 15 nm, mit noch größerem Vorzug zwischen 0,1 nm und 10 nm, mit größtem Vorzug zwischen 0,1 nm und 5 nm ausgebildet wird. Weiterhin ist es gemäß einer Ausführungsform der Erfindung vorteilhaft, wenn der mittlere Abstand B zwischen dem Reservoir und der Reaktionsschicht unmittelbar vor der Ausbildung des irreversiblen Bonds zwischen 0,1 nm und 15 nm, insbesondere zwischen 0,5 nm und 5 nm, vorzugsweise zwischen 0,5 nm und 3 nm beträgt. Der Abstand B wird erfindungsgemäß durch das Dünnen beeinflusst beziehungsweise hergestellt.

Eine Vorrichtung zur Ausführung des Verfahrens ist erfindungsgemäß mit einer Kammer zur Ausbildung des Reservoirs und einer, insbesondere separat dazu vorgesehenen Kammer zur Füllung des Reservoirs und einer, insbesondere separat vorgesehenen Kammer zur Ausbildung des Pre-Bonds ausgebildet, die direkt über ein Vakuumsystem miteinander verbunden sind.

In einer weiteren Ausführungsform kann das Auffüllen des Reservoirs auch direkt über die Atmosphäre erfolgen, also entweder in einer Kammer, die zur Atmosphäre hin geöffnet werden kann oder einfach auf einem Aufbau, welcher keine Ummantelung besitzt aber den Wafer semi- und/oder vollautomatisch handhaben kann.

Die Nutzung der Sonnenenergie mittels Photovoltaik Anlagen gewinnt zunehmend an Bedeutung, da fossile Energieträger mittelfristig knapp werden und außerdem ein erhebliches Umweltproblem in der Gewinnung und der Nutzung, insbesondere durch den Beitrag zum Treibhauseffekt darstellen. Um die Konkurrenzfähigkeit von Photovoltaik aus rein wirtschaftlicher Sicht zu stärken ist es notwendig, den Wirkungsgrad der Umwandlung von Licht in elektrische Energie bei gleichen Kosten oder maximal moderater Kostensteigerung zu verbessern. Dabei sind dem möglichen Wirkungsgrad jedoch Grenzen gesetzt. Diese Grenzen resultieren primär aus der Einschränkung, dass ein einzelnes Halbleitermaterial nur Licht mit einem eingeschränkten Wellenlängenbereich verarbeiten und in elektrische Energie umwandeln kann.

Eine Verwendung der vorliegenden Erfindung für die Herstellung von Mehrschichtsolarzelle oder noch oder unter dem Englischen Ausdruck bekannten "Multi-Junction Solar Cells" ist daher besonders vorteilhaft.

Bei diesen liegen die einzelnen Schichten vertikal übereinander gestapelt in der Solarzelle. Einfallendes Licht trifft zuerst die oberste Schicht, die dafür optimiert ist, Licht mit einem bestimmten, ersten Wellenlängenbereich in elektrische Energie umzuwandeln. Licht mit einem Wellenlängenbereich der weitgehend nicht in dieser Schicht verarbeitet werden kann, durchdringt diese erste Schicht und trifft auf die darunterliegende zweite Schicht, die dafür optimiert ist, einen zweiten Wellenlängenbereich zu verarbeiten und damit elektrische Energie zu produzieren. Optional ist es in diesen Mehrschichtzellen möglich, dass Licht mit einem Wellenlängenbereich, der auch in dieser zweiten Schicht weitgehend nicht verarbeitet werden kann, auf eine darunterliegende dritte Schicht trifft, die dafür optimiert ist, Licht mit einem dritten Wellenlängenbereich zu verarbeiten und in elektrische Energie umzuwandeln. Man kann sich vorstellen, dass rein theoretisch eine Vielzahl (n) solcher Schichten möglich ist. In der Praxis sind derartige Zellen so aufgebaut, dass die oberste Schicht, in das einfallende Licht als erstes eindringt, jenen Wellenlängenbereich mit der kürzesten Wellenlänge verarbeitet. Die zweite Schicht, den nächst kürzeren Wellenlängenbereich und so weiter. Dabei ist erfindungsgemäß nicht nur ein zweischichtiger Aufbaus denkbar sondern drei oder mehr Schichten sind realisierbar. Dabei ist es vorgesehen, die Schichten vertikal elektrisch leitfähig, d.h. mit einem möglichst geringen Widerstand und optisch transparent miteinander zu verbinden. Das Abscheiden der Schichten erfolgt dabei insbesondere durch sogenannte "Metalorganic Chemical Vapor Deposition", kurz "MO CVD" Prozesse, wobei das Abscheiden der beiden aktiven Schichten der Mehrfachzelle insbesondere "in-situ", das heißt ohne die Substrate zwischen den Abscheideprozessen der normalen Umgebungsatmosphäre auszusetzen, abgeschieden werden. Mit Vorzug werden zwischen die aktiven Schichten auch Sperrschichten (zweite oder vierte Oxidschicht) und/oder Pufferschichten (zweite oder vierte Oxidschicht) eingebracht, die die Qualität der resultierenden Zelle verbessern.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:

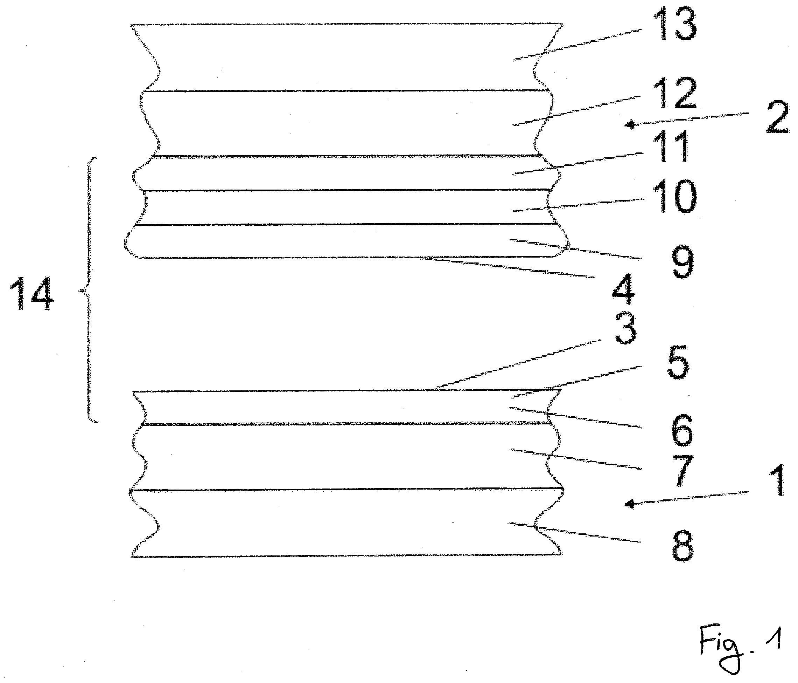

- Figur 1: eine schematische Ansicht einer Ausführungsform der vorliegenden Erfindung kurz vor dem Kontaktieren eines ersten Substrats mit einem zweiten Substrat.

Gleiche oder gleichwirkende Merkmale sind mit den gleichen Bezugszeichen gekennzeichnet.

In der in Figur 1 dargestellten Situation, die nur einen Querschnittsabschnitt einer ersten Kontaktfläche 3 eines ersten Substrats 1 und einer zweiten Kontaktfläche 4 eines zweiten Substrats 2 zeigt. Die Oberflächen der Kontaktflächen 3, 4 sind mit polaren OH-Gruppen terminiert und entsprechend hydrophil. Das erste Substrat 1 und das zweite Substrat 2 werden durch die Anziehungskraft der Wasserstoffbrücken zwischen den an der Oberfläche vorhandenen OH-Gruppen und den H₂O-Molekülen sowie zwischen den H₂O-Molekülen allein gehalten, unter anderem durch van-der-Waals-Kräfte und/oder Wasserstoffbrücken. Die Hydrophilizität zumindest des ersten Substrats 1 ist in einem vorangegangenen Schritt durch eine Plasmabehandlung erhöht worden.

Die Plasmabehandlung erfolgt in einer mit Plasma und Vakuum und/oder einer definierten Gasatmosphäre beaufschlagbaren Plasmakammer, die in einem eigenen Modul einer entsprechenden Anlage vorgesehen sein kann. Mit Vakuum und/oder einer definierten Gasatmosphäre beaufschlagbar heißt, dass Drücke unter 1 mbar einstellbar und steuerbar sind. Als Gas wird beim hier beschriebenen Ausführungsbeispiel N₂ bei einem Druck von 0,3 mbar verwendet.

Besonders vorteilhaft ist es, gemäß der alternativen Ausführungsform zusätzlich das zweite Substrat 2 beziehungsweise die zweite Kontaktfläche 4 einer Plasmabehandlung zu unterziehen, insbesondere gleichzeitig mit der Plasmabehandlung des ersten Substrats 1.

Durch die Plasmabehandlung ist erfindungsgemäß ein Reservoir 5 in einer aus dem ausgewählten TCO bestehenden Oxidschicht 6 ausgebildet worden. Unter der Oxidschicht 6 schließt sich unmittelbar ein Halbleiter 7 an, der unter anderem optional auch als Reaktionsschicht dienen kann an, die ein zweites Edukt oder eine zweite Gruppe von Edukten enthält. Durch die Plasmabehandlung mit N₂-Ionen mit der oben genannten Ionenenergie wird eine mittlere Dicke R des Reservoirs 5 von etwa 15 nm erreicht, wobei die Ionen des Plasmas Kanäle beziehungsweise Poren in der Oxidschicht 6 ausbilden. Das Reservoir wird mit einem ersten Edukt aufgefüllt, das mit dem zweiten Edukt reagiert.

Der Halbleiter 7 wird bei der gezeigten Ausführungsform durch einen Träger 8 temporär gestützt.

Das zweite Substrat 2 besteht an der zweiten Kontaktfläche 4 aus einer vierten Oxidschicht 9, unmittelbar gefolgt von einer dritten Oxidschicht 10 (Precursor-Schicht), diese wiederum unmittelbar gefolgt von einer zweiten Oxidschicht 11.

Die Oxidschicht 10 (Pre-Cursor-Schicht) besteht insbesondere aus einem TCO, in dem nicht vollständig oxidierte Komponenten enthalten sind, so dass die Schicht ein Sauerstoffvolumen S₁ aufweist, das kleiner als das maximalen Sauerstoffvolumen Sₘₐₓ ist, welches in der Schicht enthalten wäre, wenn das gesamte Volumen vollständig oxidiert wäre. Insbesondere ist das Sauerstoffvolumen S₁ maximal 70% von Sₘₐₓ Mit Vorteil liegt dieser Prozentsatz bei 55%, mit größerem Vorteil bei 40% und mit allergrößtem Vorteil bei 25%.

Die zweite Oxidschicht 11 ist fest mit einem Halbleiter 12 des zweiten Substrats 2 verbunden, der wiederum auf einem Träger 13 temporär fixiert ist.

Der Halbleiter 12 dient insbesondere als Reaktionsschicht, die ein zweites Edukt oder eine zweite Gruppe von Edukten enthält.

Jeweils zwischen den Oxidschichten 6, 9, 10, 11 und optional den Reaktionsschichten (Halbleiter 7, 12) wird durch die Reaktion des ersten Edukts mit dem zweiten Edukt eine Aufwuchsschicht gebildet.

In einer bevorzugten Ausführungsform reagiert das, in dem in der Oxidschicht 6 gebildeten Reservoir 5 eingelagerte erste Edukt mit der Pre-Cursor-Schicht 10. Diese Reaktion hat eine Volumenerhöhung zur Folge, da das Reaktionsprodukt aus dem ersten Edukt und der Pre-Cursor-Schicht ein höheres molares Volumen aufweist.

Durch Vergrößerung des molaren Volumens und Diffusion der H₂O-Moleküle wächst insbesondere an der Grenzfläche zwischen den Oxidschichten 9 und 10 Volumen jeweils in Form der Aufwuchsschicht an, wobei wegen des Ziels einer Minimierung der freien Gibb'schen Enthalpie ein verstärktes Anwachsen in Bereichen erfolgt, wo Lücken zwischen den Kontaktflächen 3, 4 vorhanden sind. Durch die Volumenerhöhung der Aufwuchsschichten werden die Lücken geschlossen.

Die Oxidschichten 6, 9, 10 und 11 bilden nach dem Bonden gemeinsam eine Verbindungsschicht 14.

Diese Verbindungsschicht besteht in einer bevorzugten Ausführungsform nach der Reaktion mit Vorteil aus einem homogenen Material, das im Wesentlichen demselben TCO entspricht, aus dem die ursprünglich abgeschiedenen Oxidschichten 9,11 und 6 bestehen.

### Bezugszeichenliste

- 1: erstes Substrat
- 2: zweites Substrat
- 3: erste Kontaktfläche
- 4: zweite Kontaktfläche
- 5,: Reservoir
- 6: Erste Oxidschicht
- 7: Erster Halbleiter
- 8: Erster Träger
- 9: Vierte Oxidschicht
- 10: Dritte Oxidschicht
- 11: Zweite Oxidschicht
- 12: Zweiter Halbleiter
- 13: Zweiter Träger
- 14: Verbindungsschicht

## Patentansprüche

1. Verfahren zum Bonden einer ersten Kontaktfläche (3) eines ersten, optisch transparenten Substrats (1) mit einer zweiten Kontaktfläche (4) eines zweiten, optisch transparenten Substrats (2), wobei an mindestens einer der Kontaktflächen (3, 4) zum Bonden ein Oxid verwendet wird, aus dem eine optisch transparente Verbindungsschicht (14) mit:
- einer elektrischen Leitfähigkeit von mindestens 10e1 S/cm (Messung: Vierpunktmethode, bezogen auf Temperatur von 300K) und
- einem optischen Transmissionsgrad größer 0,8 (für den gesamten Wellenlängenbereich von 400 nm bis 1500 nm)
an der ersten und zweiten Kontaktfläche (3, 4) ausgebildet wird, mit folgenden Schritten:
- Aufbringen einer ersten Oxidschicht (6) mit der oben genannten elektrischen Leitfähigkeit und dem oben genannten optischen Transmissionsgrad auf das erste Substrat (1),
- Aufbringen einer zweiten Oxidschicht (11) auf das zweite Substrat (2),
- Aufbringen einer dritten Oxidschicht (10) auf die zweite Oxidschicht (11), wobei die dritte Oxidschicht (10) ein Sauerstoffvolumen S₁ aufweist, das kleiner 70% des maximalen Sauerstoffvolumens Sₘₐₓ der dritten Oxidschicht (10) ist, welches in der dritten Oxidschicht (10) enthalten wäre, wenn das gesamte Volumen vollständig oxidiert wäre,
- Aufbringen einer vierten Oxidschicht (9) auf die dritte Oxidschicht (10)
- Plasma-Aktivierung des ersten Substrats (1), um ein Reservoir zur Aufnahme eines ersten Edukts im ersten Substrat (1) zu erzeugen,
- Verbonden der Substrate (1, 2) bei Raumtemperatur, wobei das in dem Reservoir eingelagerte erste Edukt während einem späteren Annealing Prozess durch die vierte Oxidschicht (9) diffundiert und die dritte Oxidschicht (10) oxidiert.

2. Verfahren nach Anspruch 1, bei dem das Oxid oder eine oder mehrere der Oxidschichten (6, 9, 10, 11), insbesondere als Dotierung, mindestens eines der folgenden Bestandteile enthält:
- Indium,
- Zinn,
- Aluminium,
- Zink,
- Gallium,
- Fluor oder
- Antimon.

3. Verfahren nach einem der vorhergehenden Ansprüche, bei dem das Oxid oder eine oder mehrere der Oxidschichten (6, 9, 10, 11) durch eines der nachfolgend aufgeführten Verfahren aufgebracht werden:
- Metalorganic Chemical Vapor Deposition **(Metallorganische Chemische Gasphasenabscheidung),**
- Metal Organic Molecular Beam Deposition **(Metallorganische Molekular Strahl Abscheidung),**
- Spray Pyrolyse **(Sprühpyrolyse),**
- Pulsed Laser Deposition **(Laserstrahlverdampfen)** oder
- Aufsputtern

## Claims

1. A method for bonding of a first contact area (3) of a first optically transparent substrate (1) to a second contact area (4) of a second optically transparent substrate (2), on at least one of the contact areas (3, 4) an oxide being used for bonding, from which an optically transparent interconnection layer (14) is formed with:
- an electrical conductivity of at least 10e¹ S/cm² (measurement: four point method, relative to temperature of 300K) and
- an optical transmittance greater than 0.8 (for the whole wavelength range from 400 nm to 1500 nm) on the first and second contact area (3, 4), with the following steps:
- Application of a first oxid layer (6) with the aforementioned electrical conductivity and the aforementioned optical txansmittance to the first substrate (1),
- Application of a second oxid layer (11) to the second substrate (2),
- Application of a third oxid layer (10) to the second oxid layer (11), the third oxide layer (10) having an oxygen volume S₁ which is smaller than 70% of the maximum oxygen volume Sₘₐₓ of the third oxide layer (10), which would be contained in the third layer (10) if the entire volume were completely oxidized,
- Application of a fourth oxid layer (9) to the third oxid layer (10),
- Plasma activating of the first substrate (1) to produce a reservoir for holding a first educt in the first substrate,
- Bonding of the substrates (1, 2) at room temperature, wherein during a subsequent annealing process the first educt intercalated in the reservoir diffuses through the fourth oxide layer (9) and oxidizes the third oxide layer (10).

2. The method as claimed in claim 1, wherein the oxide or one or more of the oxide layers (6, 9, 10, 11) contain at least one of the following components, especially as doping:
- indium,
- tin,
- aluminum,
- zinc,
- gallium,
- fluorine or
- antimony.

3. The method as claimed in one of the preceding claims, wherein the oxide or one or more of the oxide layers (6, 9, 10, 11) are applied by one of the following methods:
- metal organic chemical vapor deposition,
- metal organic molecular beam deposition,
- spray pyrolysis,
- pulsed laser deposition or
- sputtering.

## Revendications

1. Procédé destiné à la liaison d'une première surface de contact (3) d'un premier substrat optique transparent (1) avec une seconde surface de contact (4) d'un second substrat optique transparent (2), sachant que sur au moins une des surfaces de contact (3, 4), un oxyde est employé pour la liaison duquel une couche de liaison (14) optique transparente est formée avec :
- une conductibilité électrique d'au moins 10 el S/om (mesure : méthode en quatre points, rapportée à la température de 300K) et
- un degré de transmission optique supérieur à 0,8 (pour toute la plage de longueur d'onde de 400 nm à 150 nm),
sur les première et seconde surfaces de contact (3, 4), avec les étapes suivantes :
- application d'une première couche d'oxyde (6) avec la conductibilité électrique mentionnée ci-dessus et le degré de transmission optique mentionné ci-dessus, sur le premier substrat (1),
- application d'une deuxième couche d'oxyde (11) sur le second substrat (2),
- application d'une troisième couche d'oxyde (10) sur la deuxième couche d'oxyde (11), sachant que la troisième couche d'oxyde (10) présente un volume d'oxygène S1 qui est inférieur à 70 % du volume d'oxygène maximal Sₘₐₓ de la troisième couche d'oxyde (10) qui serait contenu dans la troisième couche d'oxyde (10) si le volume total était complètement oxydé,
- application d'une quatrième couche d'oxyde (9) sur la troisième couche d'oxyde (10),
- activation plasma du premier substrat (1) pour produire un réservoir destiné à recevoir un premier réactif dans le premier substrat (1),
- liaison des substrats (1, 2) à température ambiante, sachant que le premier réactif stocké dans le réservoir est diffusé par la quatrième couche d'oxyde (9) et oxyde la troisième couche d'oxyde (10), pendant un processus ultérieur de recuit.

2. Procédé selon la revendication 1, dans lequel l'oxyde ou une ou plusieurs des couches d'oxyde (6, 9, 10, 11), en particulier en tant que dopage, contient au moins l'une des composantes suivantes :
- indium
- étain
- aluminium
- zinc
- gallium
- fluor ou
- antimoine.

3. Procédé selon l'une des revendications précédentes, dans lequel l'oxyde ou une ou plusieurs des couches d'oxyde (6, 9, 10, 11) est appliqué(e)(s) est/sont appliqué(e)(s) par le biais d'un des procédés listés ci-après :
- Metalorganic Chemical Vapor Deposition (dépôt chimique en phase vapeur par composés organométalliques)
- Metal Organic Molecular Beam Deposition (dépôt chimique par jets moléculaires d'organométalliques)
- Spray Pyrolyse (pyrolyse par pulvérisation)
- Pulsed Laser Deposition (dépôt par laser pulsé) et
- pulvérisation cathodique.
